# EUROPÄISCHE PATENTSCHRIFT

(11) **EP 0 503 040 B1**
(45) Veröffentlichungstag und Bekanntmachung des Hinweises auf die Patenterteilung: **08.03.1995**
(21) Anmeldenummer: 91917483.9
(22) Anmeldetag: 02.10.1991
(51) Int. Cl.: G01S 7/48, G01S 17/02, H03K 17/94

(54) **OPTISCHE SENSORANORDNUNG UND VERFAHREN ZU DEREN BETRIEB**
OPTICAL SENSOR DEVICE AND PROCESS FOR OPERATING THE SAME
DISPOSITIF CAPTEUR OPTIQUE ET SON PROCEDE D'EXPLOITATION

(30) Priorität: 02.10.1990 DE 4031142
(43) Veröffentlichungstag der Anmeldung: 16.09.1992
(73) Patentinhaber: Erwin Sick GmbH Optik-Elektronik, D-79183 Waldkirch (DE)
(72) Erfinder: GROZINGER, Roland, D-7813 Staufen (DE); KAPPELER, Ottmar, D-7844 Neuenburg (DE); KRICKL, Herbert Kyoto Research Park, Syimogyo-ku Kyoto 6000 (JP); KUHN, Fritz, D-7808 Waldkirch (DE)
(74) Vertreter: Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.)
(86) Internationale Anmeldenummer: EP9101889
(87) Internationale Veröffentlichungsnummer: WO9206387

(56) Entgegenhaltungen:
- US-A- 4 697 904
- US-A- 4 835 403
- PATENT ABSTRACTS OF JAPAN vol. 9, no. 95 (E-310)(1818) 24. April 1985 & JP,A,59 223 024 ( FUJI DENKI SEIZO KK ) 14. Dezember 1984 siehe Zusammenfassung

## Beschreibung

Die Erfindung betrifft ein Verfahren zum Betrieb einer optischen Sensoranordnung zur Feststellung von in einem Überwachungsbereich vorhandenen Gegenständen nach dem Oberbegriff des Patentanspruchs 1 sowie eine optische Sensoranordnung nach dem Oberbegriff des Patentanspruchs 10, die aus der Druckschrift US-A-4 835 403 bekannt ist.

Bei den optischen Sensoranordnungen mit Impulsbetrieb handelt es sich um Lichtschranken im weitesten Sinne, d.h., daß unter diesen Begriff Reflexlichtschranken, Lichttaster, Abstandstaster, Sichtweitenmeßgeräte etc. fallen. Wesentlich ist, daß eine erfindungsgemäße optische Sensoranordnung ein Lichtsignal empfängt, wenn sich ein festzustellender Gegenstand im Überwachungsbereich befindet und kein Lichtsignal empfängt, wenn sich kein festzustellender Gegenstand im Überwachungsbereich befindet. Die Erfindung ist insbesondere dann mit Vorteil anwendbar, wenn die Nichterfassung eines durch den Überwachungsbereich geführten Gegenstandes unproblematisch ist, also beispielsweise keinen Gefahrenzustand nach sich zieht, auf keinen Fall aber die Anwesenheit eines Gegenstandes im Überwachungsbereich signalisiert werden darf, wenn ein solcher dort nicht vorhanden ist.

Die Erfindung wird in erster Linie dort angewandt, wo beispielsweise zu zählende Gegenstände wie Ampullen oder Verpakkungen nacheinander durch den Überwachungsbereich hindurchgeführt werden und wo unter keinen Umständen das Vorhandensein eines Gegenstandes im Überwachungsbereich vorgetäuscht werden darf.

Optische Sensoranordnungen, insbesondere Lichtschranken zur Erkennung von Gegenständen arbeiten im allgemeinen nach dem Impulsprinzip, bei dem periodisch für eine kurze Zeitdauer ein Lichtimpuls ausgesandt und das vom Gegenstand reflektierte Licht vom Lichtempfänger empfangen und in der Auswerteschaltung ausgewertet wird. Jeder Sendelichtimpuls kann z.B. eine zeitliche Länge in der Größenordnung von 1 bis 10»s haben. Nach jedem Sendelichtimpuls folgt eine vergleichsweise lange Pause, die etwa dem zehn- bis hundertfachen Wert der Sendeimpulslänge entsprechen kann. Die Verwendung von Lichtimpulsen hat zwei Vorteile. Zum einen wird dadurch gegenüber einem kontinuierlichen Sendebtrieb bei gleichen Verlustleistungen ein für die kurze Sendezeitspanne verbessertes Signal/Rauschverhältnis erzielt. Zum anderen kann durch Einschaltung eines Hochpasses in die Empfangssignalverarbeitungsstufe der Einfluß von Gleichlicht auf einfache Weise eliminiert werden.

Problematisch bei derartigen Impuls-Reflexlichtschranken ist es jedoch, daß zeitlich veränderliche Störsignale, insbesondere Störimpulse eine Verfälschung des Auswerteergebnisses nach sich ziehen können, wenn sie gerade während der Aussendung eines Sendelichtimpulses auftreten und auf optischem oder elektromagnetischem Weg in die Auswerteschaltung gelangen. Bei den Störsignalen kann es sich also sowohl um optische Störsignale als auch um elektromagnetische Störungen handeln, die im Anschluß an die optoelektronische Umwandlung im Lichtempfänger in den elektronischen Teil der Reflexlichtschranke eingekoppelt werden.

Aus diesem Grunde hat man schon versucht, durch dem Lichtempfänger folgende Filter, die nicht jedes Empfangssignal als ein Feststellungssignal weitergeben, den Einfluß von Störsignalen einzudämmen. Diese Maßnahmen haben jedoch den Nachteil, daß nur ein über einen bestimmten Zeitraum gemittelter Lichtempfangswert ausgewertet wird. Die effektive Schaltfrequenz des Ausgangssignals wird dadurch in unerwünschter Weise verringert.

Der Erfindung liegt die Aufgabe zugrunde, ein Verfahren und eine Anordnung der eingangs genannten Gattung zu schaffen, die bei unveränderter Ausgangsschaltfreguenz wesentlich störfester sind und insbesondere bei höherfrequenten, häufig auftretenden Störsingalen, wie Störlicht, eine optimale Störungseliminierung gestatten.

Zur Lösung dieser Aufgabe sind die Merkmale der kennzeichnenden Teile der Ansprüche 1 und 10 vorgesehen.

Der Grundgedanke der Erfindung besteht darin, daß die Sendelichtimpulse nicht starr periodisch ausgesandt werden, sondern daß ihre Aussendung vom Auftreten des von außen eingestreuten Störsignals abhängig gemacht wird. Zu diesem Zweck wird auch in den Zeiten, zu denen kein Sendelichtimpuls augesandt wird, ein Empfangssignal detektiert und dadurch eine Information über die Umgebung gewonnen. Durch einen geeigneten Algorithmus kann dann ein optimaler Sendezeitpunkt bestimmt werden, zu dem zumindest mit einer hohen Wahrscheinlichkeit momentan kein Störsignal vorhanden ist. Aufgrund der erfindungsgemäßen Maßnahmen wird weitgehend verhindert, daß ein von außen kommendes Störsignal das Vorhandensein eines Gegenstandes im Überwachungsbereich vortäuscht. Äußerstenfalls kann dann, wenn eine veränderliche Störung sehr lange andauern sollte, die Erkennung eines Gegenstandes ganz unterbleiben, sofern der Gegenstand in dieser Zeit wieder aus dem Überwachungsbereich herausbewegt worden sein sollte. Die Erfindung ist also insbesondere dort mit besonderem Vorteil anwendbar, wo zwar unter keinen Umständen die Vortäuschung der Anwesenheit eines Gegenstandes erfolgen darf, wo aber die gelegentliche Nichterkennung eines Gegenstandes wegen zu langen Ausbleibens eines Lichtsendeimpulses nicht schädlich ist.

Die Ausführungsform nach Anspruch 4 hat den Vorteil einer besonders einfachen Realisierungsmöglichkeit.

Für stochastisch auftretende Störungen ist es vorteilhaft, zwischen zwei Sendeimpulsen mehrmals das Vorliegen eines Störsignals zu überprüfen.

Liegt dagegen ein vorbekanntes Störungsproblem vor, das insbesondere in nach einem vorbestimmten Muster auftretenden Störungen periodischen Charakters besteht, so kann zweckmäßigerweise gemäß Anspruch 6 vorgegangen werden.

Besonders vorteilhafte praktische Realisierungen des Erfindungsgedankens sind durch die Ansprüche 7 bis 9 gekennzeichnet.

Bei einer optischen Sensoranordnung gemäß der Erfindung ist die Taktung der Empfangssignale gemäß den Ansprüchen 11 bis 14 besonders vorteilhaft, weil hierdurch mittels ein und desselben Taktgenerators die Digitalisierung des Empfangssignals herbeigeführt und gleichzeitig bei Feststellung der Abwesenheit von Störungen der Taktgenerator zur Auslösung der Sendeimpulse herangezogen werden kann.

Eine feinfühligere Auslösung kann nach Anspruch 15 erfolgen.

Die Patentansprüche 16 bis 18 definieren bevorzugte praktische Ausführungsbeispiele der optischen Sensoranordnung gemäß der Erfindung.

Sofern aufgrund von Störungen Sendeimpulse für längere Zeiten ausbleiben, soll erfindungsgemäß dafür gesorgt werden, daß in diesem Fall durch ein Alarmsignal die Bedienungsperson darauf aufmerksam gemacht werden. Dies kann z.B. gemäß Anspruch 19 geschehen. Bevorzugt sollte ein solches Alarmsignal abgegeben werden, wenn ein Sendeimpuls um mehr als eine Periode der normalen Sendeimpulsfolge verschoben ausgesendet wird. Es ist auch möglich, eine abgestufte Alarmanordnung dergestalt vorzusehen, daß bei einer vergleichsweise geringen Impulsverzögerung von einer halben bis einer ganzen Periode eine erste Alarmstufe ausgelöst wird und daß eine zweite Alarmstufe erst dann anspricht, wenn ein Sendeimpuls um ein Mehrfaches der normalen Impulsfolgeperiode verspätet ausgesendet wird.

Die Erfindung wird im folgenden beispielsweise anhand der Zeichnung beschrieben; in dieser zeigt:
- Fig. 1: ein Prinzipschaltbild einer erfindungsgemäßen Reflexlichtschranke,
- Fig. 2: zwei Intensitäts-Zeit-Diagramme zur Veranschaulichung der Funktion der Anordnung nach Fig. 1,
- Fig. 3: ein Blockschaltbild einer digital arbeitenden Reflexlichtschranke gemäß der Erfindung,
- Fig. 4: ein Blockschaltbild einer weiteren Ausführungsform, deren Funktion anhand der drei Intensitäts-Zeit-Diagramme der
- Fig. 5: erläutert wird,
- Fig. 6: ein Blockschaltbild einer weiteren Ausführungsform, deren Funktion anhand der vier Intensitäts-Zeit-Diagramme der
- Fig. 7: erläutert wird,
- Fig. 8: ein Blockschaltbild einer weiteren Ausführungsform, deren Funktion anhand der drei Intensitäts-Zeit-Diagramme der
- Fig. 9: erläutert wird,
- Fig. 10: ein Blockschaltbild einer gegenüber Fig. 3 etwas abgewandelten Ausführungsform,
- Fig. 11: drei Intensitäts-Zeit-Diagramme zur Veranschaulichung der Funktion der Blockschaltung nach Fig. 10 und die
- Fig. 12 bis 14: eine schematische Darstellung dreier verschiedender Lichtschrankentypen, bei denen die Erfindung mit Vorteil angewendet werden kann.

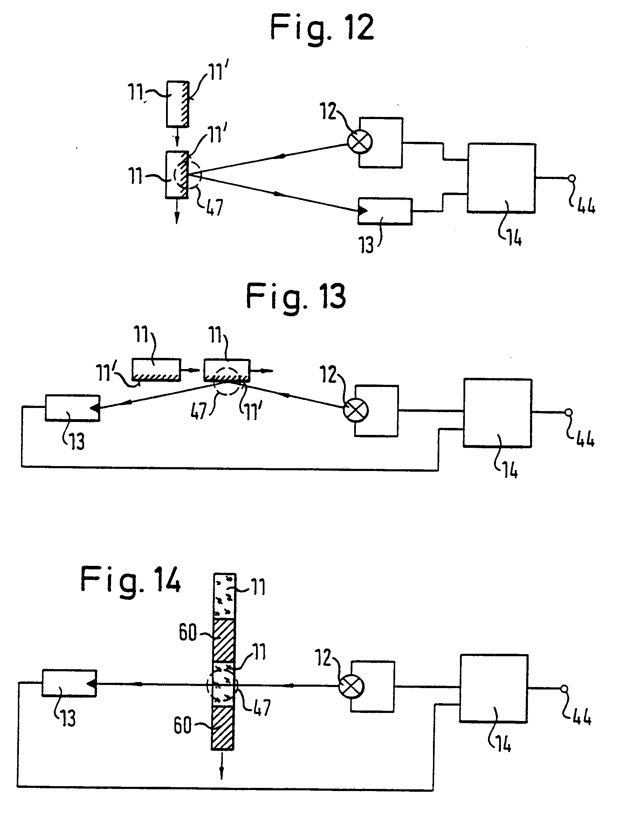

Fig. 12 zeigt schematisch eine Reflexlichtschranke mit einer einen Ausgang 44 aufweisenden Auswerteschaltung 14, welche einen Impulslichtsender 12 mit Spannungsimpulsen versorgt, damit dieser in einen Überwachungsbereich 47 Lichtblitze aussenden kann. Befindet sich im Überwachungsbereich 47 ein festzustellender Gegenstand 11 mit einer Licht spiegelnd oder streuend reflektierenden Oberfläche 11′, so wird ein Teil des Impulslichtes zu einem unmittelbar neben dem Impulslichtsender angeordneten Lichtempfänger 13 gelenkt. Das entsprechende Ausgangssignal wird der Auswerteschaltung 14 zugeführt und dahingehend ausgewertet, ob sich ein Gegenstand 11 im Überwachungsbereich 47 befindet oder nicht. Beispielsweise kann am Ausgang 44 ein elektrisches L-Signal erscheinen, wenn im Überwachungsbereich 47 ein Gegenstand 11 festgestellt wird.

Mit den Reflexlichtschranken ist es beispielsweise möglich, nacheinander durch den Überwachungsbereich 47 hindurchgehende Gegenstände festzustellen und beispielsweise zu zählen. Derartige Reflexlichtschranken werden z.B. bei der Produktion von Ampullen oder Flaschen zur Gegenstandsfeststellung verwendet.

Nach Fig. 13 können der Impulslichtsender 12 und der Lichtempfänger 13 auch gegenüberliegend angeordnet sein, wenn das Licht flach auf die reflektierenden Flächen 11′ der Gegenstände 11 im Überwachungsbereich 47 auftrifft und von dort zum Lichtempfänger 13 gelangt. Wichtig ist, daß auch in diesem Fall der Lichtempfänger 13 an die Auswerteschaltung 14 angelegt ist, die den Impulslichtsender 12 speist.

Eine andere Anwendungsmöglichkeit der Erfindung ist bei einer Lichtschranke nach Fig. 14 gegeben, wo durchsichtige Gegenstände in Richtung des Pfeiles nacheinander zwischen dem Lichtsender 12 und dem Lichtempfänger 13 hindurchgeführt werden, wobei sich zwischen den durchsichtigen Gegenständen 11 beispielsweise durch eine Blende 60 gebildete undurchsichtige Bereiche befinden.

Da aufgrund der im folgenden im einzelnen beschriebenen Erfindung die Sendelichtimpulse je nach dem Vorhandensein oder Nichtvorhandensein von Störlicht u.U. sehr stark verschoben sein können, kommt es bei allen Anwendungen der Erfindung darauf an, daß die Nichterkennung einzelner Gegenstände aufgrund verzögert auftretender Lichtimpulse nicht zu gefährlichen oder nicht mehr hinnehmbaren Zuständen führt.

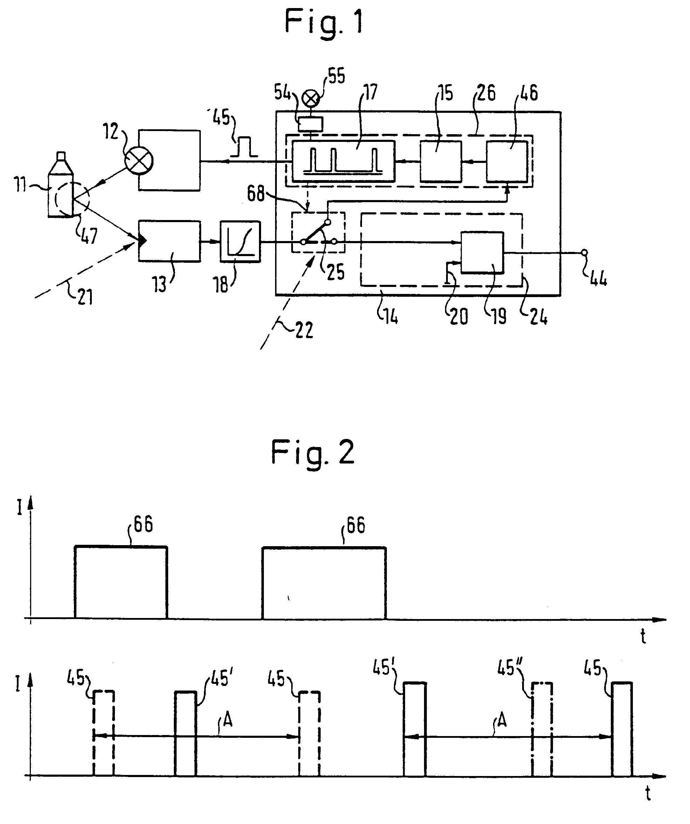

Nach Fig. 1 weist eine erfindungsgemäße, als Reflexlichtschranke ausgebildete optische Sensoranordnung einen Impulssender 12 auf, der beispielsweise 5»s lange Lichtsendeimpulse aussendet, die bei Abwesenheit von Störsignalen einen konstanten zeitlichen Abstand von beispielsweise dem 50-fachen der Impulslänge aufweisen.

Befindet sich ein lichtreflektierender Gegenstand 11 im Überwachungsbereich 47 der Reflexlichtschranke, so reflektiert er das auftreffende Licht der Lichtsendeimpulse teilweise zu einem Lichtempfänger 13, der über einen Hochpaß 18 an eine Auswerteschaltung 14 angeschlossen ist, in der sich eine über einen steuerbaren Umschalter 25 mit dem Lichtempfänger 13 verbundene Empfangssignalverarbeitungsstufe 24 befindet, die einen mit einem Schwellensignal 20 beaufschlagten Komparator 19 aufweist, welcher feststellt, ob ein ankommender Impuls oder der Mittelwert mehrerer nacheinander eintreffender Impulse größer oder kleiner als das vorzugsweise einstellbare Schwellensignal 20 ist. Ist das vom Komparator 19 festgestellte Meßsignal größer als das Schwellensignal 20, so erscheint am Ausgang 44 ein Gegenstandsfeststellungssignal.

Der Steuereingang 68 des gesteuerten Umschalters 25 ist an einen Impulsgeber 17 angeschlossen, der den Impulslichtsender 12 zur Abgabe von Lichtsendeimpulsen veranlaßt. Jedesmal wenn ein Sendeimpuls 45 an den Impulslichtsender 12 abgegeben wird, damit dieser einen Lichtsendeimpuls aussendet, wird der Umschalter 25 über ein seinem Steuereingang 68 vom Impulsgeber 17 zugeführtes Signal kurzzeitig in die in Fig. 1 gestrichelt dargestellte Position gebracht, wo er den Lichtempfänger 13 mit der Empfangssignalverarbeitungsstufe 24 verbindet, so daß das während der Dauer eines Lichtsendeimpulses vom Lichtempfänger 13 empfangene Signal in der Empfangssignalverarbeitungsstufe 24 in üblicher Weise ausgewertet werden kann.

Während der übrigen Zeiten befindet sich der Umschalter 25 in der in Fig. 1 in ausgezogenen Linien dargestellten Position, in welcher der Lichtempfänger 13 mit einer Störungsfeststellungsstufe 46 verbunden ist, die eine Sendeimpuls-Beeinflussungs- oder -auslösestufe 15 beaufschlagt, die wiederum an den Impulsgeber 17 angeschlossen ist. Die Störungsfeststellungsstufe 46, die Sendeimpuls-Beeinflussungsoder -auslösestufe 15 und der Impulsgeber 17 bilden zusammen die Sendestufe 26. Die Empfangssignalverarbeitungsstufe 24, der Umschalter 25 und die Sendestufe 26 bilden zusammen die Auswerteschaltung 14.

Sofern keine veränderlichen optischen Störsignale 21 oder elektromagnetische Störsignale 22 auf den Empfangsteil bzw. die Auswerteschaltung 14 der Reflexlichtschranke nach Fig. 1 einwirken, löst die Sendeimpuls-Beeinflussungs- oder -auslösestufe 15 in konstanten zeitlichen Abständen von beispielsweise 250»s einen Sendeimpuls 45 aus, der einen entsprechenden Lichtsendeimpuls des Impulslichtsenders 12 nach sich zieht. Bei jedem Sendeimpuls 45 schaltet der Umschalter 25 in die in Fig. 1 gestrichelt dargestellte Position um, so daß während jedes Sendeimpulses eine Auswertung des Empfangslichtes in der Empfangssignalverarbeitungsstufe 24 erfolgen kann.

In den Pausen zwischen zwei Lichtsendeimpulsen ist der Umschalter 25 in der in ausgezogenen Linien dargestellten Stellung, so daß in diesen Zeiträumen der Ausgang 44 der Empfangssignalverarbeitungsstufe 24 durch etwaige elektrische Ausgangssignale am Lichtempfänger nicht beeinflußt wird. Derartige veränderliche Störsignale, die durch Störlicht 21 oder elektromagnetische Störstrahlungen 22 erzeugt werden können, gelangen jedoch in die Störungsfeststellungsstufe 46, welche daraufhin die Sendeimpuls-Beeinflussungs- oder -auslösestufe 15 veranlaßt, die Auslösung des nächsten Sendeimpulses im Impulsgenerator 17 zu unterbinden oder zu verzögern, und zwar solange, bis von der Störungsfeststellungsstufe 46 eine Beendigung der Störung tatsächlich oder aus bestimmten Meßwerten die Beendigung der Störung als wahrscheinlich festgestellt wurde. Zu dem Zeitpunkt, wo die Störung tatsächlich beendet ist oder wo deren Ende wahrscheinlich ist, wird von der Störungsfeststellungsstufe 46 die Sendeimpuls-Beeinflussungs oder -auslösestufe 15 veranlaßt, den nächsten Sendeimpuls am Impulsgeber 17 auszulösen.

Im einfachsten Falle kann die Sendeimpuls-Beeinflussungsoder -auslösestufe 15 ein mit der Impulsfolgefrequenz arbeitende Oszillator sein, dessen Impulse unterdrückt werden, wenn kurz vor deren Aussendung durch die Störungsfeststellungsstufe 46 ein Störsignal festgestellt wird.

Da in letzterem Falle jedoch eine ganze Impulsfolgenperiode für die Messung verlorengeht, ist es bevorzugt, wenn bei Feststellung eines Störsignals durch die Störungsfeststellungsstufe 46 die Sendeimpuls-Beeinflussungs- oder -auslösestufe 15 veranlaßt wird, die Auslösung des an sich fälligen nächsten Sendeimpulses nur solange zu verzögern, bis das Störsignal zumindest weitgehend abgeklungen ist.

In Fig. 2 ist dies diagrammatisch veranschaulicht. In dem unteren Diagramm sind gestrichelt die normalerweise von der Sendeimpuls-Beeinflussungs- oder -auslösestufe 15 am Impulsgeber 17 ausgelösten Sendeimpulse bei 45 dargestellt.

Im oberen Diagramm sind zwei Störimpulse 66 wiedergegeben, die entweder optisch (21 in Fig. 1) oder elektromagnetisch (22 in Fig. 1) in den Empfang genau während der Zeiten eingekoppelt werden, wo eigentlich die zur Messung verwendeten Sendeimpulse 45 auftreten sollten.

Aufgrund der erfindungsgemäßen Verfahrensweise werden aber nun die Sendeimpulse jeweils bis zum Verschwinden der Störimpulse 66 verschoben, so daß sie tatsächlich an den Stellen 45′ in Fig. 2 auftreten, wo kein Störsignal mehr vorliegt.

Auf diese Weise ist ein störungsfreier Empfang während der Zeiten der Sendeimpulse gewährleistet.

Dem zweiten verschobenen Sendeimpuls 45′ im unteren Diagramm der Fig. 2 folgt wieder ein normaler Sendeimpuls 45 im vorgegebenen Normalabstand A. Anschließend treten dann wieder in den vorgegebenen konstanten zeitlichen Abständen Sendeimpulse 45 auf, sofern kein weiteres Störsignal in einer Impulspause empfangen wird.

Bei der vereinfachten Lösung würden einfach die Sendeimpulse 45 unterdrückt, während der nächste im vorgegebenen Abstand vorgesehene Impuls 45˝ von der Sendeimpuls-Beeinflussungsoder -auslösestufe 15 wieder freigegeben wird.

Zwischen den Sendeimpulsen ist also auf jeden Fall eine vergleichsweise lange Pause vorgesehen. Erst nach Ablauf der langen Pause werden bevorzugt die Probelichtempfänge durchgeführt. An sich ist auch eine kontinuierliche Signalauswertung möglich, es muß jedoch aus thermischen Gründen der Sendestufe 26 immer mindestens die lange Pause für einen neuen Lichtimpuls vorgegeben werden.

Nach Fig. 1 ist an den Impulsgeber 17 außerdem eine Impulsausfallfeststellungsstufe 54 angeschlossen, die wiederum mit einer Alarmvorrichtung 55 optischer oder akustischer Art verbunden ist. Hierdurch kann ein Alarmsignal abgegeben werden, wenn ein an sich fälliger Sendeimpuls 45 nach einer vorbestimmten Karenzzeit immer noch nicht aufgetreten ist. Die Bedienungsperson wird hierdurch auf die verzögerte oder möglicherweise überhaupt nicht mehr gegebene Funktionsfähigkeit der Sensoranordnung aufmerksam gemacht.

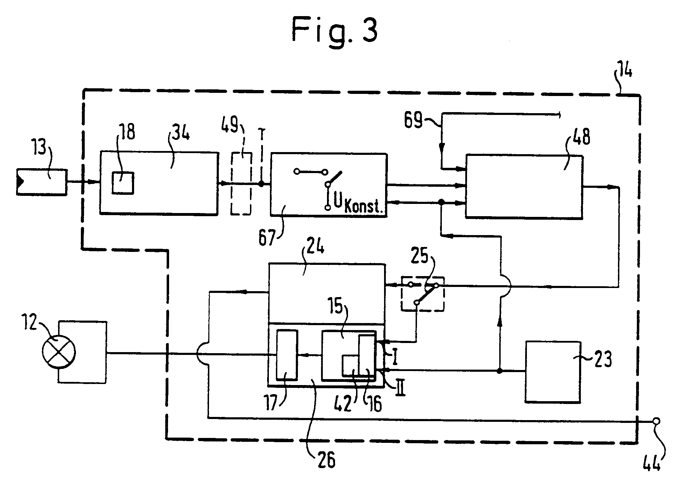

Fig. 3 zeigt ein digital arbeitendes Ausführungsbeispiel, in dem gleiche Bezugszahlen die gleichen Bauteile wie in Fig. 1 bezeichnen.

Das Ausgangssignal des Lichtempfängers 13 wird über einen einen Hochpaß 18 enthaltenden Verstärker 34 und eventuell einen Integrator 49 an einen Clamping-Schalter 67 angelegt, der mit einem Komparator 48 mit einer Referenzschwelle 69 verbunden ist.

Das Ausgangssignal des Komparators 48 ist über den Umschalter 25 parallel an die Empfangssignal-Verarbeitungsstufe 24 und die Sendestufe 26 angelegt, welche wie in Fig. 1 die Sendeimpuls-Beeinflussungs- oder -auslösestufe 15 und den Impulsgeber 17 enthält.

In der Sendeimpuls-Beeinflussungs- oder -auslösestufe 15 ist als Störungsfeststellungsstufe ein Digitalintegrator 16 beispielsweise in Form eines Zählers vorgesehen, dem einerseits das Ausgangssignal des Komparators 48 und zum anderen das Taktsignal eines Taktgenerators 23 zugeführt ist, der auch den Schalter 67 und den Komparator 48 taktet. Die Frequenz des Taktgenerators 23 beträgt ein Vielfaches, z.B. das 50bis 100-fache der Sendeimpulsfrequenz im Falle des Nichtvorliegens von Störsignalen.

Sofern zwischen den Sendeimpulsen ein Störsignal auftritt, wird dieses aufgrund des durch den Taktgenerator 23 bewirkten periodischen Schließens des Clamping-Schalters 67 an den einen Eingang des Komparators 48 angelegt, welcher jeweils ein an den Eingang I des Digitalintegrators 16 angelegtes Impulsausgangssignal abgibt, wenn die Störung die Referenzstörwelle 69 überschreitet.

Solange keine Störung vorhanden ist, zählt der Zähler bzw.

Digitalintegrator 16 die Takte des Taktgenerators 23 weil dann die Abwesenheit eines Rücksetzsignals am Eingang II des Digitalintegrator 16 Störungsfreiheit signalisiert.

Beim Auftreten eines Störungssignals am Ausgang des Komparators 48 wird der Zähler rückgesetzt. Ein Sendeimpuls wird durch die Sendeimpuls-Beeinflussungs- oder -auslösestufe 15 erst dann ausgelöst, wenn der Digitalintegrator 16 ein einen vorbestimmten und insbesondere voreinstellbaren positiven Zählerstand +N erreicht hat. Dies besagt nämlich, daß eine definierte Anzahl von Licht-Probeempfängen störungsfrei ausgefallen ist.

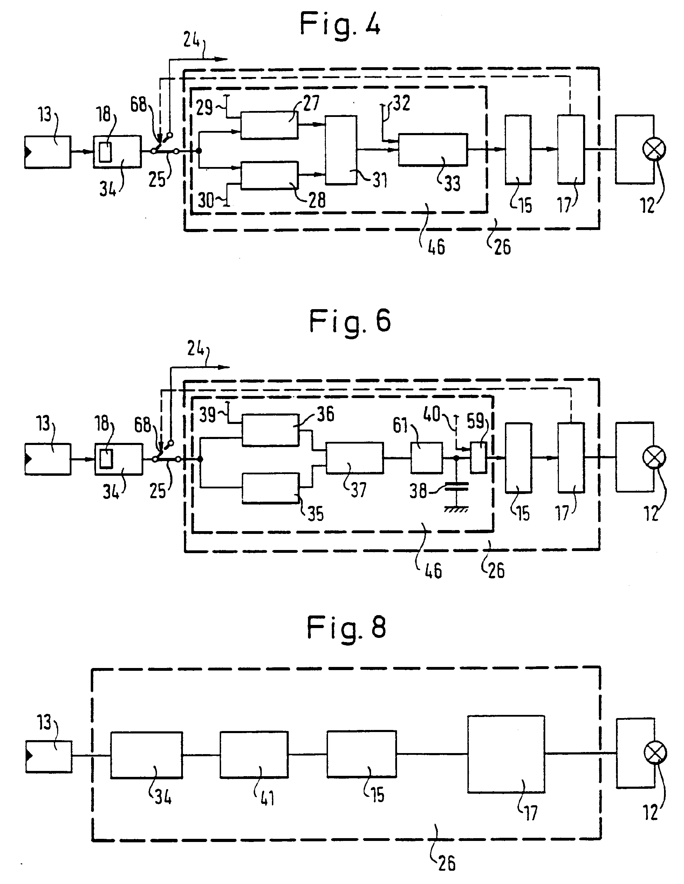

Eine wesentlich differenziertere Auswertung ist mit der Schaltung der Sendeimpuls-Beeinflussungs- oder -auslösestufe 15 nach Fig. 4 möglich. Dort wird das Ausgangssignal des Lichtempfängers 13 über einen Verstärker 34 parallel an zwei Komparatoren 27, 28 angelegt, die gemäß dem oberen Diagramm in Fig. 5 zwei unterschiedliche hohe Schwellen 29, 30 aufweisen.

Die Ausgänge der beiden Komparatoren 27, 28 sind an die beiden Eingänge eines Schwellenzeitgliedes 31 angelegt, welches bei Beaufschlagung mit einem Ausgangssignal des die höhere Schwelle 30 aufweisenden Komparators 28 angestoßen wird und ein gemäß dem mittleren Diagramm in Fig. 5 ansteigendes Ausgangssignal abgibt (Zeitpunkte t₁ und t₂). Überschreitet das Störsignal anschließend wieder die Schwelle (Zeitpunkt t₄), wird das Schwellenzeitglied 31 intern wieder zurückgesetzt.

Spricht jedoch aufgrund der Unterschreitung der Schwelle 29 der Komparator 27 an, so wird der bereits aufintegrierte Zeitwert (t₃) benutzt, um den Punkt zu finden, bei dem die Lichtaussendung erfolgen soll, die Störung also bei weiterhin angenommenem linearen Abfall zu Null werden würde. Ein an das Schwellenzeitglied 31 angeschlossener Komparator 33 mit der Schwelle 32 stellt das Unterschreiten der Schwelle 32, die Null sein kann, fest. Hierbei wird über die Sendeimpuls-Beeinflussungs- oder -auslösestufe 15 ein Sendeimpulsauslösesignal an den Impulsgeber 17 abgegeben, so daß dieser das im unteren Diagramm der Fig. 5 wiedergegebene Sendeimpulssignal 45′ abgibt.

In dem oberen Diagramm der Fig. 5 ist ein Störsignal wiedergegeben, welches bereits zu einem früheren Zeitpunkt t₁ die oberen Schwelle erstmals unterschritten hat, wodurch auch das Schwellenzeitglied 31 zum Ansteigen einer internen Integrationsspannung 51 veranlaßt wird. Da jedoch das Störsignal anschließend die Schwelle 30 wieder überschreitet wird das Schwellenzeitglied 31 intern wieder auf seinen Ausgangswert zurückgesetzt, ohne daß es zu einer Auslösung des Komparators 33 kommt.

Erst wenn auf das Durchlaufen der oberen Schwelle 30 von oben nach unten zum Zeitpunkt t₂ eine Zeit t₃ folgt, bei der auch die untere Schwelle 29 durchlaufen wird, wird das Schwellenzeitglied 31 intern so umgeschaltet, daß an seinem Ausgang eine linear abnehmende Ausgangsspannung 50 (Fig. 5) erscheint. Die Steigung der die Ausgangsspannung 50 wiedergebenden Graden muß so gering sein, daß die untere Schwelle 32 erst dann unterschritten wird, wenn das Störsignal nach einer Zeit t bereits zu Null geworden ist. Die Dauer des Vorliegens des Störsignals zwischen den Schwellen 29, 30 beeinflußt also in vorteilhafter Weise die Auslösung des Sendeimpulses.

Die Ausführungsform nach den Fig. 6 und 7 arbeitet im Anschluß an den Verstärker 34 mit einem Komparator 36, der eine Schwelle 39 besitzt und dem ein Differenzierglied 35 parallel geschaltet ist. Die Ausgänge des Differenziergliedes 35 und des Komparators 36 sind an die beiden Eingänge einer Sample-and-Hold-Schaltung 37 angeschlossen, der ein Spannungs-Strom-Konverter (61) mit einem nachgeschalteten, entsprechend dem Ausgangssignal der Schaltung 37 mit einer vorbestimmten Zeitkontstante aufladbaren Kondensator 38 folgt. Der Kondensator 38 ist an die Sendeimpuls-Beeinflussungs- oder -auslösestufe 15 angeschlossen.

Der Kondensator 38 ist an einen weiteren Komparator 59 mit der Schwelle 40 (siehe auch Fig. 7) angelegt, welcher dann, wenn die Spannung am Kondensator 38 den Referenzwert 40 überschreitet, ein entsprechendes Signal an die Sendeimpuls-Beeinflussungs- oder -auslösestufe 15 abgibt, die dann dementsprechend den Sendeimpuls auslöst.

Nach Fig. 7, oberstes Diagramm, hat das am Lichtempfänger 13 empfangene Störsignal beispielsweise eine stark abfallende Tendenz. Das differenzierte Signal am Ausgang des Differenziergliedes 35 ist im zweiten Diagramm von oben in Fig. 7 wiedergegeben. Stellt der Komparator 36 das Unterschreiten der Schwelle 39 durch das Störsignal fest, so wird an die Sample-and-Hold-Schaltung 37 ein Signal abgegeben, das gemäß dem zweiten Diagramm von oben in Fig. 7 die Festhaltung des Ausgangssignals des Differenziergliedes 35 in der Sample-and-Hold-Schaltung 37 nach sich zieht. Gleichzeitig wird von der Schaltung 37 der Beginn der Aufladung des Kondensators 38 ausgelöst, was im dritten Diagramm von oben in Fig. 7 veranschaulicht ist.

Sobald die Spannung am Kondensator 38 gemäß dem dritten Diagramm von oben in Fig. 7 die Schwelle 40 überschritten hat, wird von dem dies feststellenden Komparator 59 die Sendeimpuls-Beeinflussungs- oder -auslösestufe 15 veranlaßt, ein Auslösesignal abzugeben, das wiederum den Impulsgeber 17 veranlaßt, einen Sendeimpuls an den Impulslichtsender 12 abzugeben. Der Sendeimpuls 45′ ist im untersten Diagramm der Fig. 7 schematisch wiedergegeben.

Fig. 8 zeigt eine weitere Möglichkeit der Eliminierung von Störsignalen durch geeignete Verschiebung des Sendeimpulses 45′.

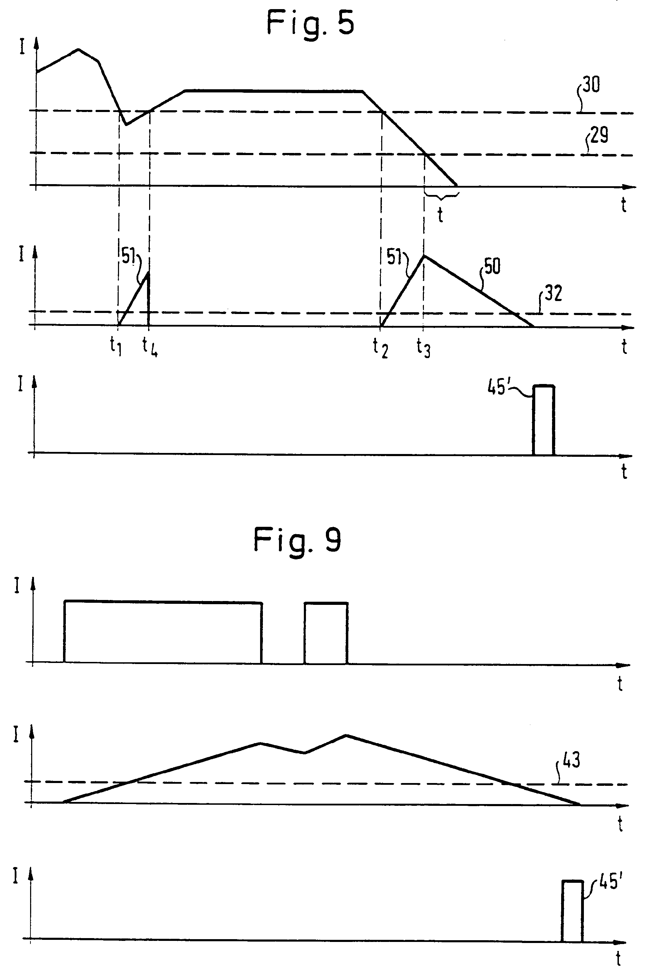

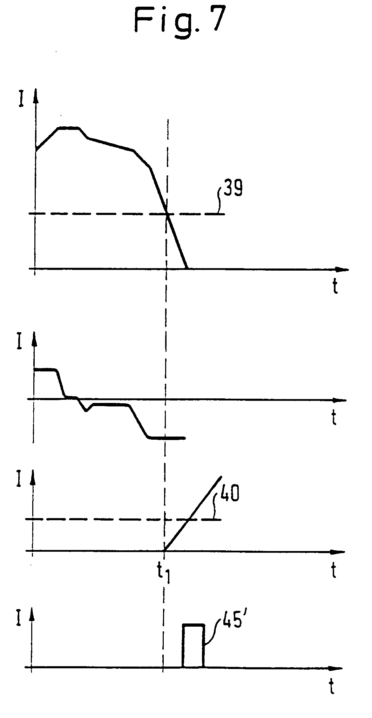

Hier wird das Aussendesignal des Verstärkers 34, der in diesem Fall einen Hochpaß enthalten kann, gleichgerichtet und an einen Tiefpaß 41 angelegt, der eine Mittelwertbildungsstufe darstellt, die gemäß dem mittleren Diagramm der Fig. 9 arbeitet, sofern die im obersten Diagramm der Fig. 9 schematisch dargestellten Störsignale vorliegen. Am Ausgang des Tiefpasses 41 liegt ein eine Schwelle 43 überschreitendes Ausgangssignal vor, das erst eine bestimmte Zeit nach Beendigung des letzten Störsignals soweit abgeklungen ist, daß es die Schwelle 43 wieder unterschreitet. Dies wird von der Sendeimpuls-Beeinflussungs- oder -auslösestufe 15 festgestellt, die daraufhin im Impulsgeber 17 den Sendeimpuls 45′ (unterstes Diagramm in Fig. 9) auslöst.

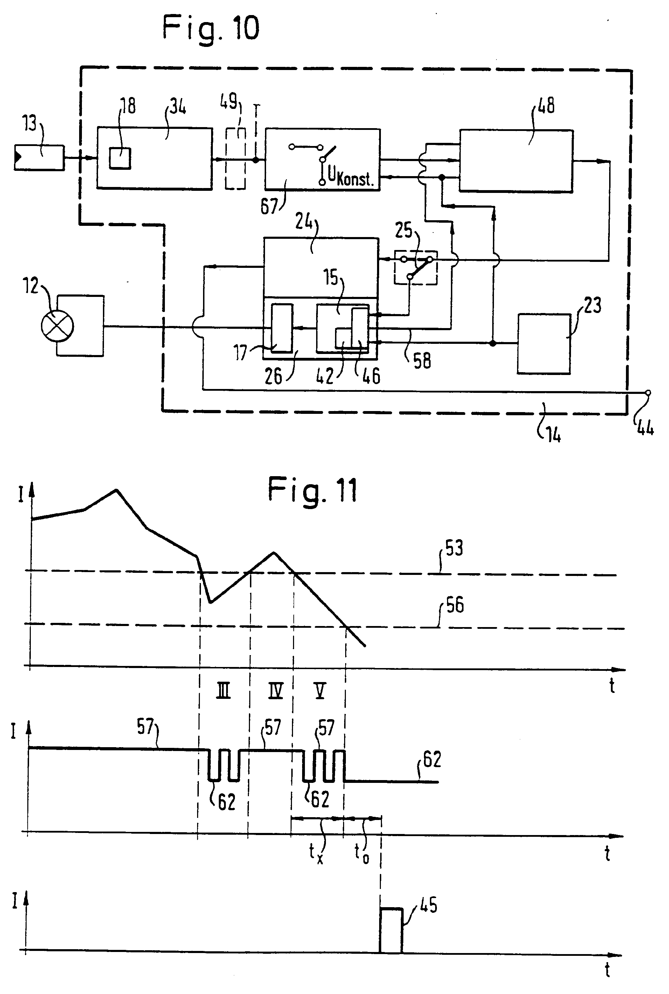

Fig. 10 zeigt eine Modifikation der Schaltung nach Fig. 3, welche darin besteht, daß an den Referenzeingang des Komparators 48 statt einer festen Schwelle 49 eine ein zweistufiges Schwellensignal führende Referenzleitung 58 angeschlossen ist, die von der Störungsfeststellungsstufe 46 abgeleitet ist, die vor der Sendeimpuls-Beeinflussungs- oder -auslösestufe 15 angeordnet ist und vom Ausgang des Komparators 48 sowie dem Taktgenerator 23 beaufschlagt ist.

Gemäß dem obersten Diagramm in Fig. 11 vermag die Störungsfeststellungstufe 46 zwischen einer oberen Schwelle 53 und einer unteren Schwelle 56 zu unterscheiden. Befindet sich das im obersten Diagramm der Fig. 11 wiedergegebene Störsignal zunächst oberhalb der oberen Schwelle 53, so erscheint am Ausgang des Komparators 48 ein Störsignal, welches die Störungsfeststellungsstufe 46 zunächst auf einem oberen Schwellenwert 57 (vgl. zweites Diagramm in Fig. 11 von oben) hält. Unterschreitet das Störsignal die obere Schwelle 53, so schaltet die Störungsfeststellungsstufe 46 zunächst auf einen niedrigeren Schwellenwert 62. Dementsprechend wird über die Leitung 58 die Referenzschwelle des Komparators 48 herabgesetzt. Liegt nun - wie das in Fig. 11 in dem Bereich III angenommen ist - die Störung zwischen den Schwellen 53 und 56, so erkennt dies die Störungsfeststellungsstufe 46 und schaltet nach einer kurzen Zeit wieder auf die obere Schwelle usw., bis im Bereich IV (Fig. 11) die Störung wieder die obere Schwelle 53 überschreitet, worauf sich die Störungsfeststellungsstufe 46 wieder auf den oberen Schwellenwert 57 fest einstellt.

Unterschreitet das Störsignal dann im Bereich V erneut die obere Schwelle 53, so wiederholt sich zunächst das Hin- und Herschalten der Störungsfeststellungsstufe 46 zwischen den Schwellenwerten 57 und 62 bis schließlich auch die untere Schwelle 56 unterschritten wird, worauf die Störungsfeststellungsstufe 46 auf dem unteren Schwellenwert 62 verbleibt und nach einer bestimmten Zeit den im unteren Diagramm der Fig. 11 angedeuteten Sendeimpuls 45 auslöst.

Erfindungsgemäß kann nun die Zeit t0 zwischen dem Zeitpunkt der Unterschreitung der unteren Schwelle 56 und der Auslösung des Sendeimpulses 45 von der Länge der Zeit tₓ abhängig gemacht werden, während der sich das Störungssignal zwischen den Schwellen 53 und 56 befindet. Je länger dieser Zeitraum tₓ ist, umso länger soll die Zeit t₀ sein, nach der der Sendeimpuls 45 ausgelöst wird. D.h., daß bei schnell abfallenden Störungen der Sendeimpuls 45 relativ kurzzeitig nach Unterschreiten der unteren Schwelle 56 ausgelöst wird, während bei lang andauernden Störungen zwischen den Schwellen 53 und 56 die Zeit bis zur Auslösung des Sendeimpulses 45 entsprechend verlängert wird.
Die Schaltung nach Fig. 10 offenbart also eine weitere Möglichkeit, wie die Abnahmegeschwindigkeit des Störungssignals bei der mehr oder weniger verzögerten Auslösung des Sendeimpulses 45 berücksichtigt werden kann.

## Patentansprüche

1. Verfahren zum Betrieb einer optischen Sensoranordnun zur Feststellung von in einem Überwachungsbereich vorhandenen Gegenständen mit einem nacheinander einen zeitlichen Abstand aufweisende Lichtimpulse in den Überwachungsbereich aussendenden Impulslichtsender und einem Lichtempfänger, der bei Abwesenheit von festzustellenden Gegenständen im Überwachungsbereich im wesentlichen kein Licht vom Lichtempfänger empfängt, jedoch bei Anwesenheit eines festzustellenden Gegenstandes im Überwachungsbereich durch Reflexion oder Transmission so viel Licht vom Lichtsender erhält, daß eine an dem Lichtempfänger angeschlossene Empfangssignalverarbeitungsstufe ein Gegenstands-Feststellungssignal abgibt,
dadurch **gekennzeichnet**,
daß nach Aussendung eines Sende-Lichtimpulses die Empfangssignalverarbeitungsstufe (24) abgeschaltet und das Ausgangssignal des Lichtempfängers (13) zumindest im Endbereich der anschließenden Pause bis zum nächsten vorgesehenen Sendeimpuls (45) daraufhin untersucht wird, ob ein veränderliches Störsignal vorhanden ist, und daß bei Feststellung eines veränderlichen Störsignales die Aussendung des nächsten Sendeimpulses zeitlich soweit verschoben wird, daß bei Aussendung des nächsten Sendeimpulses das Störsignal zumindest mit einer bestimmten Wahrscheinlichkeit bis unter die Ansprechschwelle der Empfangssignalverarbeitungsstufe (24) abgesunken ist.

2. Verfahren nach Anspruch 1,
dadurch **gekennzeichnet**,
daß das Ergebnis eines ausgesandten Sende-Lichtimpulses zwischengespeichert und nur dann ein Gegenstands-Feststellungssignal ausgelöst wird, wenn ein Gegenstand erkannt wurde und zugleich nicht nur vor, sondern auch nach Aussenden des Sende-Lichtimpulses kein veränderliches Störsignal festgestellt wurde.

3. Verfahren nach Anspruch 2,
dadurch **gekennzeichnet**,
daß die Dauer der auf Vorliegen eines veränderlichen Störsignals untersuchten Zeitintervalle vor und nach Aussenden des Sende-Lichtimpulses gleich groß ist.

4. Verfahren nach einem des Ansprüche 1 bis 3
dadurch **gekennzeichnet**,
daß ein bestimmter Sendeimpuls nur dann eine vorbestimmte Zeit nach den vorangehenden Sendeimpulsen abgegeben wird, wenn kurz vor dem vorgesehenen Sendezeitpunkt kein Störsignal vorliegt, und daß bei Vorliegen eines solchen Störsignals die Aussendung des Sendeimpulses um eine bestimmte Zeit, die vorzugsweise dem im störungsfreien Fall vorhandenen festen Zeitabstand zwischen zwei Sendeimpulsen entspricht, verschoben wird, und daß die Aussendung des Sendeimpulses auch nach dieser Zeit nur dann erfolgt, wenn nicht kurz zuvor ein Störsignal festgestellt wurde, usw..

5. Verfahren nach einem der Ansprüche 1 bis 3,
dadurch **gekennzeichnet**,
daß ein Sendeimpuls erst dann abgegeben wird, wenn in mehreren zeitlichen Abständen, die jeweils dem normalen zeitlichen Abstand zwischen zwei Sendeimpulsen entsprechen, keine Störsignale kurz vor Ablauf dieser Zeiten festgestellt wurden.

6. Verfahren nach einem der Ansprüche 1 bis 3,
dadurch **gekennzeichnet**,
daß bei Feststellung einer Störung mit periodischem Charakter während der Störlicht-Empfangsperioden zwischen den Sendelichtimpulsen die Aussendung der Lichtimpulse derart vorgenommen wird, daß sie im Mittenbereich der störungsfreien Periode erfolgt.

7. Verfahren nach einem der Ansprüche 1 bis 3,
dadurch **gekennzeichnet**,
daß die Änderung des Störsignals nach Betrag und Richtung ermittelt wird, indem vorzugsweise das veränderliche Störsignal bezüglich zweier unterschiedlicher Schwellen (29, 30; 53; 56) oder mittels eines Differenziergliedes (35) untersucht wird, wobei die Aussendung eines Sendeimpulses nur dann erfolgt, wenn das Störsignal abnimmt, wobei vorzugsweise derjenige Wert des Störsignals extrapoliert wird, wo das Störsignal zu Null geworden sein müßte, und die Aussendung des Sendeimpulses erst nach diesem Wert erfolgt.

8. Verfahren nach einem der Ansprüche 1 bis 3,
dadurch **gekennzeichnet**,
daß das Empfangssignal des Lichtempfängers über eine längere Zeit nach einem Sendeimpuls zeitlich gemittelt wird und daß nur, wenn ab einer vorbestimmten Zeit seit dem letzten Sendeimpuls dieses Signal einen vorbestimmten Wert unterschreitet, der nächste Sendeimpuls ausgelöst wird.

9. Verfahren nach einem der vorhergehenden Ansprüche,
dadurch **gekennzeichnet**,
daß die Ansprechschwelle für die Feststellung eines Störsignals deutlich niedriger liegt als die Ansprechschwelle der Empfangssignalverarbeitungsstufe (24).

10. Optische Sensoranordnung zur Feststellung von in einem Überwachungsbereich vorhandenen Gegenständen mit einem nacheinander einen zeitlichen Abstand aufweisende Lichtimpulse in den Überwachungsbereich aussendenden Impulslichtsender und einem Lichtempfänger, der relativ zum Lichtsender und zum Überwachungsbereich so angeordnet ist, daß er bei Abwesenheit von festzustellenden Gegenständen im Überwachungsbereich zumindest im wesentlichen kein Licht vom Lichtempfänger empfängt, jedoch bei Anwesenheit eines festzustellenden Gegenstandes im Überwachungsbereich durch Reflexion oder Transmission so viel Licht vom Lichtsender erhält, daß eine an den Lichtempfänger angeschlossene Empfangssignalverarbeitungsstufe ein Gegenstands-Feststellungssignal abgibt,
dadurch **gekennzeichnet**,
daß an den Lichtempfänger (13) auch eine Störungsfeststellungsstufe (16; 46) angeschlossen bzw. anschließbar ist, welche bei Feststellung eines veränderlichen Störsignalempfanges eine anschließende Sendeimpuls-Beeinflussungs- oder -auslösestufe (15) veranlaßt, die Aussendung des nächsten Sendeimpulses durch den von der Sendeimpuls-Beeinflussungs- oder -auslösestufe (15) beaufschlagten Impulsgeber (17) erst nach der tatsächlichen oder voraussichtlichen Beendigung des veränderlichen Störsignales auszulösen, und daß in den Pfad zwischen dem Lichtempfänger (13) und der Empfangssignalverarbeitungsstufe (24) ein gesteuerter Umschalter (25) eingeschaltet ist, der nur bei Abgabe eines Sendeimpulses durch den Impulsgeber (17) so geschaltet ist, daß er den Lichtempfänger (13) mit der Empfangssignalverarbeitungsstufe (24) verbindet, in der Pause zwischen zwei Sendeimpulsen hingegen den Lichtempfänger (13) zumindest kurz vor der Auslösung des nächsten Sendeimpulses, vorzugsweise aber während des gesamten Zeitraumes zwischen der Aussendung zweier aufeinanderfolgender Sendeimpulse mit der Störungsfeststellungsstufe (16; 46) bzw. Sendeimpuls-Beeinflussungs- oder -auslösestufe (15) verbindet.

11. Optische Sensoranordnung nach Anspruch 10,
dadurch **gekennzeichnet**,
daß ein Taktgenerator (23) mit einer größenordnungsmäßig höheren Frequenz als die Normal-Lichtimpulsfrequenz das Empfangssignal digitalisiert, daß die hierdurch gebildeten einzelnen Empfangsimpulse in der Sendeimpuls-Beeinflussungs- oder -auslösestufe (15) auf das Vorhandensein oder Nichtvorhandensein einer Störung untersucht werden und daß über die Sendeimpuls-Beeinflussungs- oder -auslösestufe (15) die Auslösung eines Sendeimpulses im Impulsgeber (17) veranlaßt wird, wenn bei einer vorbestimmten Anzahl von vorzugsweise aufeinanderfolgenden Empfangsimpulsen keine Störung festgestellt wurde.

12. Optische Sensoranordnung nach Anspruch 11,
dadurch **gekennzeichnet**,
daß der die Sendeimpuls-Beeinflussungs- oder -auslösestufe eine an den Taktgenerator (23) angeschlossene Impulsuntersetzungsstufe (42) umfaßt, die erst nach einer Vielzahl von, insbesondere 50 bis 100, Taktimpulsen einen Sendeimpuls auslöst, und daß beim Auftreten nur eines gestörten Empfangsimpulses die Störungsfeststellungsstufe (16; 46) die Auslösung eines Sendeimpulses durch die Impulsuntersetzungsstufe (42) bzw. die Sendeimpuls-Beeinflussungs- oder -auslösestufe (15) unterbindet, bis die vorbestimmte Anzahl ungestörter Empfangsimpulse ermittelt worden ist.

13. Optische Sensoranordnung nach Anspruch 11 oder 12,
dadurch **gekennzeichnet**,
daß der Taktgenerator (23) einen mit der SendeimpulsBeeinflussungs- oder -auslösestufe (15) verbundenen, die Störungsfeststellungsstufe darstellenden Digitalintegrator (16) taktet, an den das getaktete und nach Störung oder Nicht-Störung bewertete Empfangssignal angeschlossen ist und welcher die Sendeimpuls-Beeinflussungs- oder -auslösestufe (15) veranlaßt, einen Sendeimpuls im Impulsgeber (17) erst nach Vorliegen einer bestimmten Anzahl störungsfreier Empfangsimpulse auszulösen, wobei insbesondere der Digitalintegrator (16) nach Auftreten nur eines einzigen gestörten Empfangsimpulses auf Null zurückgesetzt wird und ein Sendeimpuls erst dann ausgelöst wird, wenn der Digitalintegrator (16) eine vorbestimmte Anzahl (N) ungestörter Empfangsimpulse gezählt hat.

14. Optische Sensoranordnung nach Anspruch 13,
dadurch **gekennzeichnet**,
daß an den Rücksetzeingang (I) des Digitalintegrators (16) das Ausgangssignal eines ebenfalls getakteten Komparators (48) mit fester Schwelle (69) angelegt ist, dem die Empfangsimpulse zugeführt sind.

15. Optische Sensoranordnung nach Anspruch 10 bis 12,
dadurch **gekennzeichnet**,
daß an die Störungsfeststellungsstufe (46) das Ausgangssignal eines vorzugsweise getakteten Komparators (48) angelegt ist, dem ein zweistufiges Schwellensignal (58) von der Störungsfeststellungsstufe (46) zugeführt ist, die zwischen zwei Schwellenwerten (57, 62) hin- und herschaltet, wenn nur die obere Schwelle (53) vom Störsignal unterschritten wird, und auf den unteren Schwellenwert (62) schaltet, wenn auch die untere Schwelle (56) unterschritten wird, und daß der Sendeimpuls (45) erst danach ausgelöst wird, und zwar vorzugsweise umso später, je länger das Störsignal einen Wert zwischen den beiden Schwellen (53, 56) annimmt.

16. Optische Sensoranordnung nach Anspruch 10,
dadurch **gekennzeichnet**,
die Sendeimpuls-Auslösestufe (15) im Anschluß an einen vom Lichtempfänger (13) beaufschlagten Verstärker (34) zwei parallel geschaltete Komparatoren (27, 28) mit unterschiedlichen Schwellen (29, 30) aufweist, wobei bei Unterschreiten der oberen Schwelle (30) durch das Empfangssignal eine interne Signalzunahme in einem anschließenden Schwellenzeitglied (31) mit angeschlossenem Komparator (33) ausgelöst wird und bei Unterschreiten auch der unteren Schwelle (29) ein von dem erreichten Signalzunahmewert ab stetig, insbesondere linear abnehmender externer Signalausgang am Komparator (33) herbeigeführt wird, und daß erst dann, wenn das externe Signal des Schwellenzeitgliedes (31) die Schwelle (32) des Komparators (33) unterschreitet, ein Sendeimpuls ausgelöst wird.

17. Optische Sensoranordnung nach Anspruch 10,
dadurch **gekennzeichnet**,
daß sie im Anschluß an einen vom Lichtempfänger (13) beaufschlagten Verstärker (34) einen mit einem Differenzierglied (35) parallel geschalteten ersten Komparator (36) mit einer ersten Schwelle (39) aufweist, deren Ausgänge den beiden Eingängen einer Sample-and-Hold-Schaltung (37) zugeführt sind, der ein Spannungs-StromKonverter (61) mit einem nachgeschaltetem Ladeglied, insbesondere einem Kondensator (38) folgt, welcher bei Erreichen einer vorbestimmten Spannung über einen Komparator (59) mit einer Schwelle (40) in der Sendeimpuls-Beeinflussungs- oder -auslösestufe (15) die Abgabe eines Sendeimpuls-Auslösesignals an den Impulsgeber (17) veranlaßt.

18. Optische Sensoranordnung nach Anspruch 10,
dadurch **gekennzeichnet**,
daß die Sendeimpuls-Beeinflussungs- und -auslösestufe (15) von einer im Anschluß an einen vom Lichtempfänger (13) beaufschlagten Verstärker (34) vorgesehenen Mittelwertbildungsstufe (41), z.B. in Form eines Tiefpasses beaufschlagt ist, die über die Sendeimpuls-Beeinflussungs- oder -auslösestufe (15) im Impulsgeber (17) einen Sendeimpuls auslöst, wenn nach einer bestimmten Zeit seit dem letzten Sendeimpuls der Mittelwert eine vorbestimmte Schwelle (43) unterschreitet.

19. Optische Sensoranordnung nach einem der Ansprüche 10 bis 18,
dadurch **gekennzeichnet**,
daß eine Impulsausfall-Feststellungsstufe (54) vorgesehen ist, die bei Ausbleiben eines Sendeimpulses inner halb eines vorbestimmten Zeitraumes nach Aussendung des letzten Sendeimpulses eine Alarmvorrichtung (55) auslöst.

## Claims

1. Method for the operation of an optical sensor arrangement for the detection of articles present in a monitored region with a pulsed light transmitter which transmits light pulses with a time spacing one after the other into the monitored region and with a light receiver which in the absence of articles to be detected receives substantially no light from the light receiver, but which on the presence of an article to be detected in the monitored region receives so much light from the light transmitter by reflection or transmission that a received signal processing stage connected to the light receiver transmits an article detection signal, characterised in that, after transmitting a transmitted light pulse, the received signal processing stage (24) is switched off and the output signal of the light receiver (13) is investigated, at least in the end region of the subsequent pause until the next transmitted pulse (45), as to whether a varying disturbing signal is present; and in that, on finding a varying disturbing signal, the transmission of the next transmitted pulse is shifted timewise by an amount such that on transmitting the next transmitted pulse the disturbing signal has sunk, at least with a certain probability below the response threshold of the received signal processing circuit (24).

2. Method in accordance with claim 1, characterised in that the result of a transmitted light pulse is temporarily stored and an article detection signal is only then triggered when an article was recognised and at the same time no variable disturbing signal was determined not only prior to but also after transmission of the transmitted light pulse.

3. Method in accordance with claim 2, characterised in that the durations of the time intervals investigated for the presence of a variable disturbing signal prior to and after transmission of the transmitted light pulse are of the same size.

4. Method in accordance with one of the claims 1 to 3, characterised in that a specific transmitted pulse is only then transmitted a predetermined time after the preceding transmitted pulses when no disturbing signal is present shortly before the intended time of transmission; and in that, in the presence of such a disturbing signal, the transmission of the transmitted pulse is shifted by a predetermined time which preferably corresponds to the fixed time interval present between two transmitted pulses in the disturbance-free case; and in that the transmission of the transmitted pulse after even this time only then takes place when a disturbing signal has not been found shortly before it, etc.

5. Method in accordance with one of the claims 1 to 3, characterised in that a transmitted pulse is first transmitted when no disturbing signals were found in several time intervals which respectively correspond to the normal time interval between two transmitted pulses shortly before the expiry of these times.

6. Method in accordance with one of the claims 1 to 3, characterised in that, on detecting a disturbance with periodic character during the disturbed light receiving periods between the transmitted light pulses, the transmission of the light pulses is effected such that it takes place in the center region of the disturbance-free periods.

7. Method in accordance with one of the claims 1 to 3, characterised in that the change of the disturbing signal is determined with respect to its magnitude and direction in that the changing disturbing signal is preferably investigated with respect to two different thresholds (29, 30; 53; 56), or by means of a differentiation element (35), with the transmission of a transmitted pulse only then taking place when the disturbing signal reduces, with that value of the disturbing signal preferably being extrapolated where the disturbing signal should reduce to zero, and with the transmission of the transmitted pulse first taking place after this value.

8. Method in accordance with one of the claims 1 to 3, characterised in that the received signal of the light receiver is time-averaged over a long time after a transmitted pulse; and in that the next transmitted pulse is only triggered when, after a predetermined time since the last transmitted pulse, this signal falls beneath a predetermined value.

9. Method in accordance with one of the preceding claims, characterised in that the response threshold for the detection of a disturbing signal lies substantially lower than the response threshold of the received signal processing stage (24).

10. Optical sensor arrangement for detecting articles present in a monitored region comprising a pulsed light transmitter which transmits light pulses having a time spacing one after the other into the monitored region, and a light receiver which is so arranged relative to the light transmitter and the monitored region that, in the absence of articles to be detected in the monitored region, it receives at least substantially no light from the light receiver but on the presence of an article to be detected in the monitored region, it receives so much light from the light transmitter through reflection or transmission that a received signal processing stage connected to the light receiver transmits an article detection signal, characterised in that a disturbance detection stage (16; 46) is also connected or connectable to the light receiver (13) and causes, on detecting reception of a variable disturbing signal, a subsequent transmitted pulse influencing or trigger stage (15) to trigger the transmission of the next transmitted pulse by the pulse generator (17) activated by the transmitted pulse influencing or trigger stage (15) only after the actual or probable end of the varying disturbing signal; and in that a controlled change-over switch (25) is inserted in the path between the light receiver (13) and the received signal processing stage (24) and is so switched, that it connects the light receiver (13) with the received signal processing stage (24) only on the transmission of a transmitted pulse by the pulse transducer (17) but, in contrast, in the pause between two transmitted pulses, connects the light receiver (13) at least shortly before the triggering of the next transmitted pulse, preferably however during the entire time interval between the sending of two sequential transmitted pulses, to the disturbance detection stage (16; 46) and/or to the transmitted pulse influencing or trigger stage (15).

11. Optical sensor arrangement in accordance with claim 10, characterised in that a clock generator (23) with a frequency of a higher order of magnitude than the normal light pulse frequency digitises the received signal; in that the individual received pulses formed in this way are investigated in the transmitted pulse influencing or trigger stage (15) for the presence or absence of a disturbance; and in that the triggering of a transmitted pulse in the pulse transducer (17) is caused via the transmitted pulse influencing or trigger stage (15) when no disturbance has been found with a predetermined number of preferably sequential received pulses.

12. Optical sensor arrangement in accordance with claim 11, characterised in that the transmitted pulse influencing or trigger stage includes a pulse step down stage (42) connected to the clock generator (23) which first triggers a transmitted pulse only after a plurality of in particular 50 to 100 clock pulses; and in that on the occurrence of only one disturbed received pulse the disturbance detection stage (16, 46) prevents the initiation of a transmitted pulse through the pulse step down stage (42), or through the transmitted pulse influencing or trigger stage (15), until the predetermined number of undisturbed received pulses has been found.

13. Optical sensor arrangement in accordance with claim 11 or claim 12, characterised in that the clock generator (23) clocks a digital integrator (16) connected to the transmitted pulse influencing or trigger stage (15) representing the disturbance detection stage, with the clocked received signal which is evaluated in accordance with disturbance or non-disturbance being connected to the digital integrator, and with the latter causing the transmitted pulse influencing or trigger stage (15) to initiate a transmitted pulse in the pulse transducer (17) only on the presence of a specific number of disturbance-free received pulses, with the digital integrator (16) in particular being reset to zero after the occurrence of only a single disturbed received pulse and with a transmitted pulse only then being triggered when the digital integrator (16) has counted a predetermined number (N) of undisturbed received pulses.

14. Optical sensor arrangement in accordance with claim 13, characterised in that the output signal of a likewise clocked comparator (48) with a fixed threshold (69) to which the received pulses are supplied is connected to the resetting input (I) of the digital integrator (16).

15. Optical sensor arrangement in accordance with claim 10 to 12, characterised in that the output signal of a preferably clocked comparator (48), to which a two stage threshold signal (58) is supplied from the disturbance detection stage (46), is applied to the disturbance detection stage (46) and switches to and fro between two threshold values (57, 62) when the disturbed signal only falls short of the upper threshold (53) and switches to the lower threshold value (62) when the signal also does not reach the lower threshold (56); and in that the transmitted pulse (45) is only triggered thereafter, and indeed preferably the later the longer the disturbing signal adopts a value between the two thresholds (53, 56).

16. Optical sensor arrangement in accordance with claim 10, characterised in that the transmitted pulse trigger stage (15) has, following an amplifier (34) fed by the light receiver (13), two comparators (27, 28) with different thresholds (29, 30) and connected in parallel, wherein, when the received signal falls short of the upper threshold (30), an internal signal increase is triggered in a subsequent threshold time circuit (31) with an attached comparator (33) and wherein, on also falling short of the lower threshold (29), an external signal output to the comparator (33) is effected which continuously decreases from the achieved signal increase value, and in particular decreases linearly, and in that a transmitted pulse is triggered only when the external signal of the threshold time circuit (31) falls short of the threshold (32) of the comparator (33).

17. Optical sensor arrangement in accordance with claim 10, characterised in that it has, following an amplifier (34) which is fed by the light receiver (13), a first comparator (36) with a first threshold (39) and connected in parallel with a differentiating circuit (35), the outputs of which are supplied to the two inputs of a sample and hold circuit (37) which follows a voltage current converter (61) with a subsequent charging element, in particular a capacitor (38), which, on achieving a predetermined voltage, causes, via a comparator (59) with a threshold (40), the transmission in the transmitted pulse influencing or trigger stage (15) of a transmitted pulse trigger signal to the pulse generator (17).

18. Optical sensor arrangement in accordance with claim 10, characterised in that the transmitted pulse influencing and trigger stage (15) is acted on by a mean value forming stage (41), for example in the form of a low pass filter, provided following an amplifier (34) fed by the light receiver (13), with the mean value forming stage triggering a transmitted pulse in the pulse generator (17) via the transmitted pulse influencing or trigger stage (15) when, after a specific time since the last transmitted pulse, the mean value falls below a predetermined threshold (43).

19. Optical sensor arrangement in accordance with one of the claims 10 to 18, characterised in that a missing pulse detection stage (54) is provided which triggers an alarm device (55) in the absence of a transmitted pulse within a predetermined time interval after the transmission of the last transmitted pulse.

## Revendications

1. Procédé d'exploitation d'un dispositif capteur optique, pour détecter des objets se trouvant dans une zone de surveillance, avec un émetteur d'impulsions lumineuses envoyant dans la zone de surveillance des impulsions lumineuses se suivant les unes après les autres avec un espacement temporel et pratiquement aucune lumière n'étant reçue par le photorécepteur en cas d'absence d'objet à détecter dans la zone de surveillance, alors que, cependant, en cas de presence d'un objet à détecter dans la zone de surveillance, le photocapteur reçoit par reflexion ou transmission, venant du photoémetteur, une quantité de lumière telle qu'un étage de traitement de signal de reception raccordé au photocapteur envoie un signal de detection d'objets,
caractérisé en ce qu'après envoi d'une impulsion lumineuse d'émission, l'étage de traitement de signal de reception (24) est mis hors service et le signal de sortie du photorécepteur (13) est, suite à cela, exploré, au mains dans la zone finale allant de la pause subséquente jusqu'à l'impulsion d'émission (45) prévue pour être la suivante, afin de détecter si l'on est en présence d'un signal parasite variable et en ce que, en cas de detection d'un signal parasite variable, l'envoi de l'impulsion d'émission subséquente est décalé temporellement, dans une mesure telle que, lors de l'envoi de l'impulsion d'émission suivante, le signal parasite aura chuté au-dessous du seuil de reaction de l'étage de traitement de signal de reception (24), ceci avec au moins une probabilité déterminée.

2. Procédé selon la revendication 1, caractérisé en ce que le résultat d'une impulsion lumineuse d'émission envoyée est soumis à un stockage intermédiaire et qu'un signal de detection d'objets n'est déclenché que lorsqu'un objet a été identifié et que, en même temps, aucun signal parasite variable n'a été detecte, non seulement avant, mais également après envoi de l'impulsion lumineuse d'émission.

3. Procédé selon la revendication 2, caractérisé en ce que la durée de l'intervalle de temps exploré pour rechercher la présence d'un signal parasite variable est de valeur égale, avant et après envoi de l'impulsion lumineuse d'émission.

4. Procédé selon l'une des revendications 1 à 3, caractérisé en ce qu'une impulsion d'émission déterminée n'est envoyée qu'après écoulement d'une durée prédéterminée après les impulsions d'émission précédentes, lorsque, peu avant le moment de l'envoi prévu, aucun signal parasite n'est présent et que, en cas de présence d'un tel signal parasite, l'envoi de l'impulsion d'émission est décalé d'une durée déterminée, correspondant de préférence au premier intervalle de temps fixe existant dans le cas où il y a absence de parasite, entre deux impulsions d'émission, et en ce que l'envoi de l'impulsion d'émission s'effectue après écoulement de cette durée seulement lorsque, peu avant, aucun signal parasite n'a été détecté, etc..

5. Procédé selon l'une des revendications 1 à 3, caractérisé en ce qu'une impulsion d'émission n'est envoyée que, lorsque, au cours de plusieurs intervalles de temps, correspondant chacun à l'intervalle de temps normal entre deux impulsions d'émission, aucun signal parasite n'a été constaté peu avant écoulement de ces durées.

6. Procédé selon l'une des revendications 1 à 3, caractérisé en ce qu'en cas de constatation d'une perturbation de caractère périodique pendant les périodes de réception de lumière parasite entre les impulsions d'émission de lumière, on effectue l'envoi de l'impulsion lumineuse de manière à ce qu'elle s'effectue dans la plage médiane de la période exempte de perturbation ou parasite.

7. Procédé selon l'une des revendications 1 à 3, caractérisé en ce que la modification du signal parasite est déterminée en amplitude et en direction, en examinant de préférence le signal parasite variable par rapport à deux seuils (29, 30; 53; 56) différents, ou au moyen d'un organe formateur de différence (35) , l'envoi d'une impulsion d'émission ne s'effectuant que lorsque le signal parasite diminue, une extrapolation de la valeur du signal parasite étant de préférence effectuée pour trouver le moment où ce signal parasite aurait dû devenir égal à zéro, et l'émission de l'émission de l'impulsion d'émission s'effectuant alors une fois cette valeur atteinte.

8. Procédé selon l'une des revendications 1 à 3, caractérisé en ce que la moyenne du signal de réception du photorécepteur est déterminée temporellement, sur une longue durée, après une impulsion d'émission, et que l'impulsion d'émission subséquente n'est déclenchée qu'après écoulement d'une durée déterminée, seulement une fois que, après écoulement d'une durée déterminée depuis le dernier signal d'émission, ce signal est descendu au-dessous d'une valeur prédéterminée.

9. Procédé selon l'une des revendications précédentes, caractérisé en ce que le seuil de réaction de constatation d'un signal parasite est situé à une valeur nettement inférieure au seuil de réaction de l'étage de traitement de signal d'entrée (24).

10. Dispositif capteur optique, pour détecter des objets se trouvant dans une zone de surveillance, avec un émetteur d'impulsions lumineuses envoyant dans la zone de surveillance des impulsions lumineuses présentant, les unes à la suite des autres, un intervalle de temps et un photocapteur, disposé, par rapport au photoémetteur et à la zone de surveillance, de manière que, en cas d'absence d'objets à détecter dans la zone de surveillance, pratiquement aucune lumière ne soit reçue par le photorécepteur, alors que, en cas de la présence d'un objet à détecter, dans la zone de surveillance, de la lumière soit reçue par réflexion ou transmission, venant du photoémetteur, en une quantité faisant qu'un étage de traitement de signal de réception raccordé au photorécepteur envoie un signal de détection d'objets, caractérisé en ce qu'au photocapteur (13) est également raccordé, respectivement peut être raccordé, un étage de détection de parasite (16; 46) qui, en cas de détection de la réception d'un signal parasite variable, autorise un étage d'influence ou de déclenchement (15) d'impulsion d'émission, à déclencher l'envoi de l'impulsion d'émission subséquente au moyen du transducteur d'impulsions (17) sollicité par l'étage d'influence ou de déclenchement (15) d'impulsion d'émission, une fois que le signal parasite variable effectif ou prévu a cessé, et en ce que, dans le trajet entre le photocapteur (13) et l'étage de traitement de signal de réception (24), est mis en circuit un commutateur (25) commandé, qui n'est mis en service qu'en cas d'émission d'une impulsion d'émission par le transducteur d'impulsions (17), de manière qu'il relie le photocapteur (13) à l'étage de traitement de signal de réception (24) et, par contre, relie pendant la pause existant entre deux impulsions d'émission, le photocapteur (13) au moins peu avant déclenchement de l'impulsion d'émission subséquente, de préférence cependant pendant la totalité de l'intervalle de temps entre l'envoi de deux impulsions d'émission successives, à l'étage de détection de parasite (16; 46), respectivement à l'étage d'influence ou de déclenchement (15) d'impulsion d'émission.

11. Dispositif capteur optique selon la revendication 10, caractérisé en ce qu'un générateur de cadencement (23) ayant une fréquence d'un ordre de grandeur supérieur à la fréquence normale d'impulsion lumineuse numérise le signal de réception, en ce que les impulsions de réception individuelles ainsi constituées sont examinées dans l'étage d'influence ou de déclenchement (15) d'impulsion d'émission pour rechercher la présence ou l'absence d'une perturbation ou d'un parasite et en ce que, par l'intermédiaire de l'étage d'influence ou de déclenchement (15) d'impulsion d'émission, le déclenchement d'une impulsion d'émission dans le transducteur d'impulsions (17) est autorisé lorsqu'il a été constaté qu'aucun parasite ne se trouvait parmi un nombre prédéterminé d'impulsions de réception de préférence se suivant les unes les autres.

12. Dispositif capteur optique selon la revendication 11, caractérisé en ce que l'étage d'influence ou de déclenchement d'impulsion d'émission comprend un étage de cessation d'impulsion (42) raccordé au générateur de cadencement (23) qui, après un nombre donné, en particulier de 50 à 100, d'impulsions de cadencement déclenche une impulsion d'émission et en ce que, en cas d'apparition seulement d'un signal de réception parasitée, l'étage de détection de parasite (16; 46) fait cesser le déclenchement d'une impulsion d'émission par l'étage de cessation d'impulsion (42) ou l'étage d'influence ou de déclenchement (15) d'impulsion d'émission,- jusqu'à ce que le nombre prédéterminé d'impulsions de réception non-parasitées ait été atteint.

13. Dispositif capteur optique selon la revendication 11 ou 12, caractérisé en ce que le générateur de cadencement (23) cadence un intégrateur numérique (16), relié à l'étage d'influence ou de déclenchement (15) d'impulsion d'émission, constituant l'étage de détection de parasite, intégrateur numérique (16) auquel est raccordé le signal de réception cadencé est évalué quant au fait qu'il soit parasité ou non-parasité et autorisant l'étage d'influence ou de déclenchement (15) d'impulsion d'émission à déclencher ensuite une impulsion d'émission dans le transducteur d'impulsions (17), une fois en présence d'un nombre déterminé d'impulsions de réception non-parasitées, en particulier l'intégrateur numérique (16) étant ramené à zéro après apparition d'une seule impulsion de réception parasitée et une impulsion d'émission étant déclenchée ensuite lorsque l'intégrateur numérique (16) a compté un nombre (N) déterminé d'impulsions de réception non-parasitées.

14. Dispositif capteur optique selon la revendication 13, caractérisé en ce qu'à l'entrée de remise à état initial (I) de l'intégrateur numérique (16) est appliqué, le signal de sortie d'un comparateur (48), également cadencé, avec un seuil (69) fixe et auquel est amenée l'impulsion de réception.

15. Dispositif capteur optique selon les revendications 10 à 12, caractérisé en ce qu'à l'étage de détection de parasite (46) est appliqué le signal de sortie d'un comparateur (48), de préférence cadencé, auquel est amené un signal de seuil (58) à deux niveaux venant de l'étage de détection de parasite (46), évoluant entre deux valeurs de seuil (57, 62), lorsque seul le seuil supérieur (53) a été franchi en descente par le signal parasite, et passant à la valeur de seuil inférieure (62), lorsqu'également le seuil inférieur (56) a été franchi en descente, et en ce que l'impulsion d'émission (45) est ensuite déclenchée, notamment d'autant plus tard que le signal parasite a pris pendant une durée longue une valeur entre les deux seuils (53, 56).

16. Dispositif capteur optique selon la revendication 10, caractérisé en ce que l'étage de déclenchement d'impulsion d'émission (15) présente, raccordé à un amplificateur (34) alimenté par le photocapteur (13), deux comparateurs (27, 28) branchés en parallèle ayant des seuils (29, 30) différents, en cas de descente au-dessous du seuil supérieur (30) une augmentation interne du signal étant déclenchée dans un organe temporisé à seuil (31) raccordé, auquel est raccordé un comparateur (33), du fait du signal de réception, et, en cas de descente également au-dessous du seuil inférieur (29), une sortie de signal étant provoquée au comparateur (33), allant en diminuant en particulier de façon linéaire, constante, à partir de la valeur augmentée atteinte du signal, et en ce qu'ensuite, lorsque le signal externe de l'organe temporisé à seuil (31) est descendu au-dessous du seuil (32) du comparateur (33), une impulsion d'émission est déclenchée.

17. Dispositif capteur optique selon la revendication 10, caractérisé en ce qu'il présente, raccordé à un amplificateur (34) alimenté par le photocapteur (13), un premier comparateur (36) branché en parallèle avec un organe formateur de différence (35) et avec un premier seuil (39), comparateur dont les sorties sont amenées aux deux entrées d'un circuit d'échantillonnage et de maintien (37) qui est mis en circuit avec un convertisseur tension-intensité (61) ayant un organe de charge aval, en particulier un condensateur (38), qui, une fois atteinte une tension prédéterminée, autorise, par l'intermédiaire d'un comparateur (39) doté d'un seuil (40), dans l'étage d'influence ou de déclenchement (15) d'impulsion d'émission, l'envoi d'un signal de déclenchement d'impulsion d'émission au transducteur d'impulsions (17).

18. Dispositif capteur optique selon la revendication 10, caractérisé en ce que l'organe d'influence et de déclenchement (15) d'impulsion d'émission est alimenté par un organe de formation de valeur moyenne (41) , se présentant par exemple sous la forme d'un filtre passe-bas, prévu raccordé à un amplificateur (34) alimenté par le photocapteur (13), l'étage (41) déclenchant par l'intermédiaire de l'étage d'influence ou de déclenchement (15) d'impulsion d'émission, dans le transducteur d'impulsions (17), une impulsion d'émission lorsqu'après écoulement d'une durée déterminée, depuis la dernière impulsion d'émission, il y a eu descente de la valeur moyenne au-dessous d'un seuil (43) prédéterminé.

19. Dispositif capteur optique selon l'une des revendications 10 à 18, caractérisé en ce qu'est prévu un étage de détection d'absence d'impulsion (54), qui déclenche un dispositif d'alarme (55) lorsqu'il y a absence d'une impulsion d'émission dans les limites d'un intervalle de temps prédéterminé, après envoi de la dernière impulsion d'émission.
